# EUROPEAN PATENT APPLICATION

(11) **EP 3 965 167 A1**
(43) Date of publication of application: **09.03.2022**
(21) Application number: 20922354.4
(22) Date of filing: 03.12.2020
(51) Int. Cl.: H01L 29/94, H01L 27/108

(54) **SEMICONDUCTOR STRUCTURE AND FORMING METHOD THEREFOR**

(30) Priority: 27.02.2020 CN 202010123360
(71) Applicant: Changxin Memory Technologies, Inc., Hefei, Anhui 230601 (CN)
(72) Inventor: LEE, Jinil, Hefei, Anhui 230601 (CN)
(74) Representative: V.O.
(86) International application number: PCT/CN2020/133567
(87) International publication number: WO 2021/169462

(57) **Abstract**

The present disclosure relates to the technical field of semiconductor manufacturing, and in particular, to a semiconductor structure and a forming method thereof. The semiconductor structure comprises: a substrate, a trench extending in the direction of the substrate being provided in the substrate; a capacitor, the trench being filled with the capacitor, and the capacitor comprising a lower electrode disposed on the inner wall of the trench, a dielectric combination layer disposed on the lower electrode, and an upper electrode disposed on the dielectric combination layer, the dielectric combination layer comprising a laminated structure composed of a nitride and an oxide. The present invention can greatly increase the capacitance value of a capacitor, reducing the occurrence of electricity leakage, thereby improving the electrical properties of the semiconductor memory.

## Description

### CROSS-REFERENCE TO RELATED APPLICATION

This application claims priority to the China Patent Application No. 202010123360.6, filed on February 27, 2020 and entitled "Semiconductor Structure and Forming Method Thereof', which is hereby incorporated by reference in its entirety.

### TECHNICAL FIELD

The present disclosure relates to the technical field of semiconductor manufacturing, in particular to a semiconductor structure and a method of forming the same.

### BACKGROUND

As the critical dimensions of semiconductor devices continue to shrink in accordance with Moore's Law, the dimensions of DRAM capacitors have been continuously reduced. Most of capacitors in existing DRAMs are cylindrical capacitors with a high aspect ratio. However, as the sizes of the DRAMs continue to shrink, the spaces used to form the electrodes and the dielectrics in the cylindrical capacitors are getting smaller and smaller, which eventually leads to significant decreases in the capacitance values of cylindrical capacitors. The reduction of the capacitance values will seriously affect DRAM performance.

Therefore, how to maintain a high capacitance value to improve DRAM's performance while keeping DRAM size reduced has become an urgent problem to solve.

### SUMMARY

The present disclosure provides a semiconductor structure and a forming method thereof, in order to solve the existing low capacitance problem and improve the performance of a semiconductor memory.

In order to solve the above problem, a semiconductor structure is provided, comprising: a substrate in which a trench extending along a direction of the substrate; a capacitor filled in the trench, in which the capacitor comprises a lower electrode provided on an inner wall of the trench, a dielectric combination layer provided on the lower electrode and an upper electrode provided on the dielectric combination layer, and the dielectric combination layer comprises a stacked structure composed of a nitride and an oxide.

Optionally, the substrate further comprises a first-type doped region and a second-type doped region located above the first-type doped region, in which the trench penetrates the second-type doping region and extends to the first-type doped region, and wherein the lower electrode covers on the inner wall of the trench in the first-type doped region.

Optionally, the dielectric combination layer is disposed in the trench in the first-type doped region.

Optionally, the semiconductor structure further comprises a capacitor contact structure formed above the upper electrode and connected to the upper electrode.

Optionally, the semiconductor structure further comprises an isolation structure formed above the lower electrode, which covers a top surface of the lower electrode, for isolating the lower electrode from the capacitor contact structure.

Optionally, the oxide comprises one or more of ZrO₂, Ta₂O₅, Al₂O₃, TiO₂, and HfO₂.

In order to solve the above problem, a method for forming a semiconductor structure is provide, which comprises steps of: providing a substrate, in which a trench extends along a direction of the substrate; filling a capacitor in the trench, wherein the capacitor comprises a lower electrode disposed on an inner wall of the trench, a dielectric combination layer disposed on the lower electrode and an upper electrode disposed on the dielectric combination layer, in which the dielectric combination layer comprises a stacked structure composed of a nitride and an oxide.

Optionally, the substrate further comprises a first-type doped region and a second-type doped region located above the first-type doped region, in which the trench penetrates the second-type doped region and extends to the first-type doped region; and filling the capacitor in the trench comprises forming the lower electrode covering the inner wall of the trench in the first-type doped region.

Optionally, filling the capacitor in the trench further comprises forming the dielectric combination layer in the trench in the first-type doped region, in which the dielectric combination layer covers a surface of the lower electrode.

Optionally, the method further comprises forming a capacitor contact structure above the upper electrode, which is electrically connected to the upper electrode, after filling the capacitor in the trench.

Optionally, the method further comprises forming an isolation structure above the lower electrode, in which the isolation structure covers a top surface of the lower electrode for isolating the lower electrode from the capacitor contact structure.

Optionally, the oxide comprises one or more of ZrO₂, Ta₂O₅, Al₂O₃, TiO₂ and HfO₂.

On one hand, according to the semiconductor structure and the method for forming the same, surface areas of the lower electrode, the dielectric layer and the upper electrode are increased by filling the capacitor in the trench formed in the substrate, so as to increase the capacitance value of the capacitor. Therefore, the capacitance value of a capacitor can be kept at a relatively high level as the size of a DRAM shrinks. On the other hand, with the arrangement of a dielectric combination layer including a nitride/oxide stacked structure between the upper electrode and the lower electrode of the capacitor, the dielectric constant of the dielectric combination layer is greatly increased, thus the leakage current is avoided, and the capacitor's capacitance value is increased, thereby improving the electrical performance of the semiconductor structure.

### BRIEF DESCRIPTION OF THE DRAWINGS

FIG. 1 shows a schematic cross-sectional view of a semiconductor structure from an angle according to an embodiment of the present disclosure;
FIG. 2 shows a schematic cross-sectional view of a semiconductor structure from another angle according to an embodiment of the present disclosure;
FIG. 3 shows a schematic diagram of a partial circuit structure of a semiconductor structure according to an embodiment of the present disclosure;
FIG. 4 shows a flowchart of the method for forming the semiconductor structure according to an embodiment of the present disclosure; and
FIGs. 5A-5E are schematic cross-sectional views of the semiconductor structure at main steps in the formation process according to an embodiment of the present disclosure.

### DETAILED DESCRIPTION

Specific embodiments of a semiconductor structure and a forming method thereof provided by the present disclosure will be described in detail below in combination with the accompanying drawings.

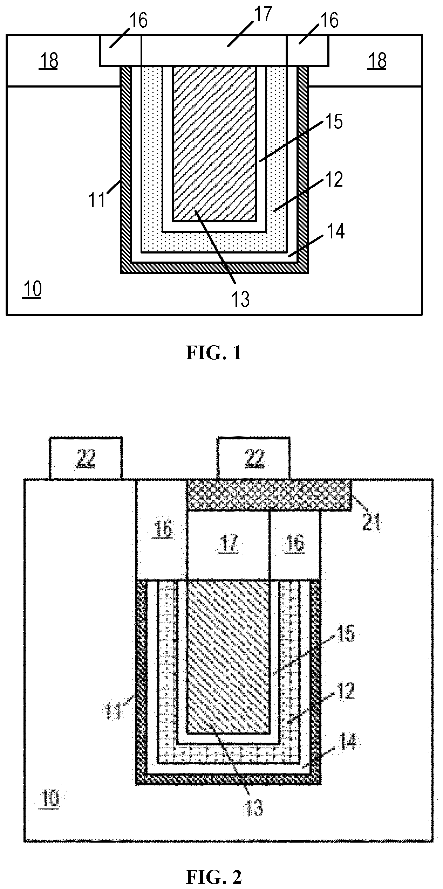

An embodiment provides a semiconductor structure. FIG. 1 shows a cross-sectional view of the semiconductor structure from one angle. FIG. 2 shows a cross-sectional view of the semiconductor structure from another angle. As shown in FIG. 1 and FIG. 2, the semiconductor structure provided by this embodiment includes: a substrate in which a trench extending in a direction of the substrate; a capacitor which is filled in the trench. The capacitor includes a lower electrode 11 disposed on the inner wall of the trench, a dielectric combination layer disposed on the lower electrode 11, and an upper electrode 13 disposed on the dielectric combination layer;

The dielectric combination layer includes a stacked structure composed of nitride and oxide.

Specifically, the material of the substrate may be silicon but not limited to it. The substrate includes a region 10 doped with the first-type of dopant, and a region 18 doped with a second-type of dopant, the region 18 is located above the first-type doped region 10. The conductivity types of the second-type doped region 18 and the first-type doped region 10 are opposite. For example, the first-type doped region 10 is doped with P-type ions, and the second-type doped region 18 is doped with N-type ions, or the first-type doped region 10 is doped with N-type ions, and the second-type doped region 18 is doped with P-type ions. The trench extends in a direction perpendicular to the substrate. The lower electrode 11 covers the side wall and bottom wall of the trench, and the dielectric combination layer is filled in the trench and covers the surface of the electrode 11 opposite from the surface of the inner wall of the trench, the upper electrode 13 is filled in the trench and covers the surface of the dielectric combination layer opposite from the lower electrode 11. The upper electrode 13 fills up the region surrounded by the dielectric combination layer to form a plug-like shape.

The dielectric combination layer includes a stacked structure composed of a nitride and a oxide, where the nitride and the oxide are stacked in a radial direction of the trench. The nitride may be located on the surface of the oxide facing the lower electrode 11, may be located on the surface of the oxide facing the upper electrode 13, or may be located on the surface of the oxide facing the lower electrode 11 surface and on the surface of the oxide facing the upper electrode 13 (that is, the nitride is located on both opposite sides of the oxide), which can be set by those skilled in the art according to actual needs.

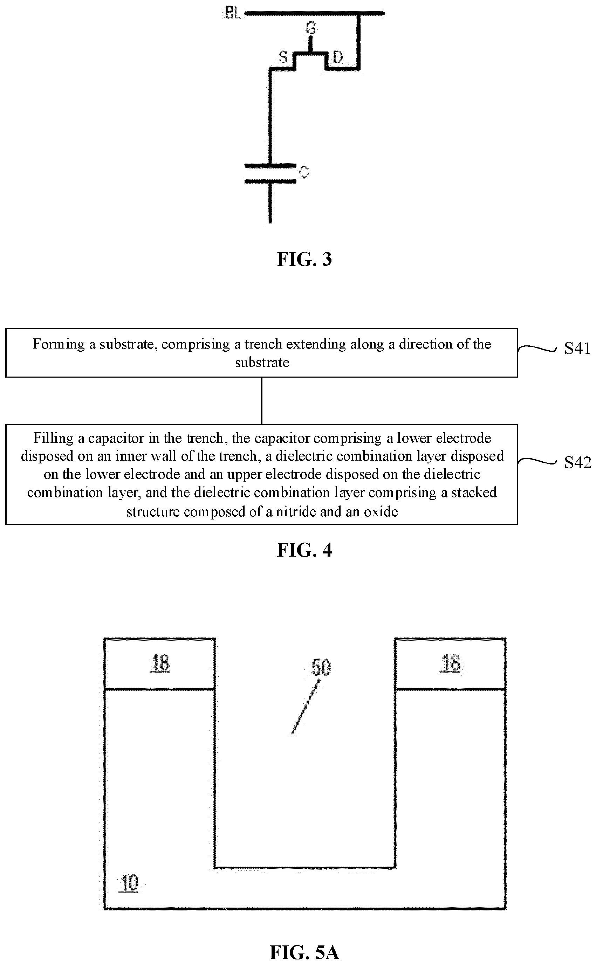

FIG. 3 is a schematic diagram of a partial circuit of the semiconductor device according to an embodiment of the present disclosure. As shown in FIG. 2 and FIG. 3, in this embodiment, the capacitor C and the transistor are both disposed in the substrate, and the capacitor is disposed under the transistor, and the gate G of the transistor is electrically connected to the word line 22, the source S is electrically connected to the capacitor, and the drain D is electrically connected to the bit line BL. The capacitor and the word line 22 are electrically isolated by an STI (shallow trench isolation structure) 21.

The material of the lower electrode 11 and the upper electrode 13 may be, but not limited to, a metal material (such as metal tungsten) or a polysilicon material. For example, the material of the lower electrode 11 and the upper electrode 13 is N-type ions doped polysilicon or P-type ions doped polysilicon. When the lower electrode 11 is a polysilicon material doped with N-type ions, and the first-type doped region 10 is a silicon substrate also doped with N-type ions, the dopants in the lower electrode 11 and the first-type doped region 10 may be the same or may be different. The dopant concentration in the lower electrode 11 may be 10¹⁹ cm⁻³, and the dopant concentration in the first-type doped region 10 can be 10¹⁷ cm⁻³.

In this embodiment, a trench is formed in the substrate 10 and a capacitor is filled in the trench to form a trench-type capacitor. On one hand, the limitation of surface areas of the lower electrode, the dielectric layer and the upper electrode due to shrinkage of the DRAM size can be avoided, thus helpful to increase the capacitance of the capacitor, thereby keeping the capacitance of the capacitor at a relatively high level so as to improve the electrical performance of the DRAM. On the other hand, , it facilitates to simplify the capacitor formation process and facilitates to optimize the overall morphology of the capacitor by adopting the trench filling process to form the capacitor, thereby ensuring the performance stability of the DRAM. Also, by adopting the dielectric combination layer including a stacked structure composed of a nitride and an oxide, not only the leakage phenomenon is avoided, but also the overall dielectric constant of the dielectric combination layer is effectively increased, thereby further increases the capacitor's capacitance and improves the electrical performance of the semiconductor structure.

The specific dimensions of the trench (for example, the depth and width of the trench) can be set by those of ordinary skill in the art according to actual needs, for example, according to the capacitance value required by the DRAM device. Optionally, the depth of the trench is 15 µm-100 µm.

Optionally, the substrate includes a first-type doped region 10 and a second-type doped region 18 located above the first-type doped region 10, and the trench passes through the second-type doped region 18 and extends to the first-type doped region 10, and the lower electrode 11 covers the inner walls of the trench in the first-type doped region 10.

Optionally, the dielectric combination layer is located in the trench in the first-type doped region 10.

Specifically, the trench penetrates the second-type doped region 18 and extends to the inside of the first-type doped region 10, and both the lower electrode 11 and the dielectric combination layer cover at least the inner walls of the trench in the first doped region 11. For example, both the lower electrode 11 and the dielectric combination layer may only cover the inner walls of the trench located in the first-type doped region 10, or may cover the inner walls of the trench located in the first-type doped region 10 and part of the inner walls of the trench located in the second-type doped region 18.

Optionally, the top surface of the lower electrode 11 is flush with the top surface of the dielectric combination layer.

The top surface of the upper electrode 13 is flush with the top surface of the dielectric combination layer; or the top surface of the upper electrode 13 protrudes above the top surface of the dielectric combination layer.

Specifically, as shown in FIG. 1, the heights at each of the top surfaces of the lower electrode 11, the stacked dielectric composed of a nitride and an oxide, and the upper electrode 13 are the same, that is, the lower electrode 11, the stacked dielectric composed of a nitride and an oxide are both flush with the top surface of the upper electrode 13. In other specific embodiments, those skilled in the art can also make the height of the top surface of the lower electrode 11 the same as the height of the top surface of the stacked structure composed of a nitride and an oxide according to actual needs, and the upper electrode 13 protrudes above the top surface of the lower electrode 11 in a direction perpendicular to the substrate.

Optionally, the semiconductor structure further includes a capacitor contact structure 17 formed above the upper electrode 13 and connected to the upper electrode.

Optionally, the semiconductor structure further includes an isolation structure.

The isolation structure 16 is formed above the lower electrode 11 and covers the top surface of the top surface of the lower electrode 11 to isolate the lower electrode 11 from the capacitor contact structure 17.

Specifically, the material of the capacitor contact structure 17 may be a conductive material such as a metal or polysilicon. The specific shape of the capacitor contact structure 17 can be selected according to actual needs by those of ordinary skill in the art, for example, it may be a cylindrical shape extending in a direction perpendicular to the substrate. The capacitor contact structure 17 is disposed on the top surface of the upper electrode 13 and is used to lead out the upper electrode 13 so that the upper electrode 13 is electrically connected to the source S of the transistor (FIG. 3).

To avoid electrical crosstalk between the capacitor contact structure 17 and the lower electrode 11 and to avoid electrical crosstalk between the upper electrode 13 and the lower electrode 11, the isolation structure 16 is disposed on the top surface of the lower electrode 11. For example, the isolation layer 16 may be arranged around the outer circumference of the capacitor contact structure 17. The material of the isolation layer 16 may be, but is not limited to, an oxide material.

Optionally, the stacked structure composed of a nitride and an oxide includes an oxide and a nitride.

The oxide 12 is disposed between the lower electrode 11 and the upper electrode 13.

The nitride 14 is disposed between the lower electrode 11 and the oxide 12 to prevent the lower electrode 11 from being oxidized.

Optionally, the capacitor further includes an adhesion layer 15 disposed between the oxide layer 12 and the upper electrode 13.

Specifically, in order to prevent the surface of the lower electrode 11 from being oxidized during the process of depositing the oxide layer 12, which affects the conductivity of the lower electrode 11, a nitride layer 14 is arranged between the oxide layer 12 and the lower electrode 11 according to this embodiment. The material of the nitride layer 14 may be silicon nitride. The thickness of the nitride layer 14 is preferably greater than 15 Å.

By disposing the adhesion layer 15 between the oxide layer 12 and the upper electrode 13, the adhering strength between the dielectric combination layer and the upper electrode 13 will be enhanced. The material of the adhesion layer 15 may be a titanium nitride material. The thickness of the adhesion layer 15 is preferably greater than 30 Å.

Optionally, the oxide includes one or a combination of two or more of ZrO₂, Ta₂O₅, Al₂O₃, TiO₂ and HfO₂.

Specifically, ZrO₂, Ta₂O₅, Al₂O₃, TiO₂ and HfO₂ and other materials have high dielectric constants. Applying a high dielectric constant material as the oxide layer 12 helps to reduce the leakage current inside the capacitor, thereby increasing the capacitance value of the capacitor.

In addition, embodiments of this disclosure also provide a method for forming a semiconductor structure. FIG. 4 shows a schematic flowchart of a method for forming a semiconductor structure in an embodiment of the present disclosure, and FIGS. 5A-5E illustrate schematic cross-section views of a semiconductor structure at the main the processes for forming the semiconductor structure according to an embodiment. FIGS. 1 to 3 illustrate the specific semiconductor structures formed in this embodiment. Referring to FIGS. 1 to 4 and 5A to 5E, the method for forming the semiconductor structure provided in this embodiment includes the following steps.

In step S41, a substrate is formed, and the substrate has a trench 50 extending along the planar direction of the substrate, as shown in FIG. 5A.

Specifically, the depth and width of the trench 50 can be set according to the size and/or the capacitance of a capacitor required. For example, the depth of the trench 50 is 15 µm-100 µm. The trench 50 may be formed by a dry etching process or a wet etching process.

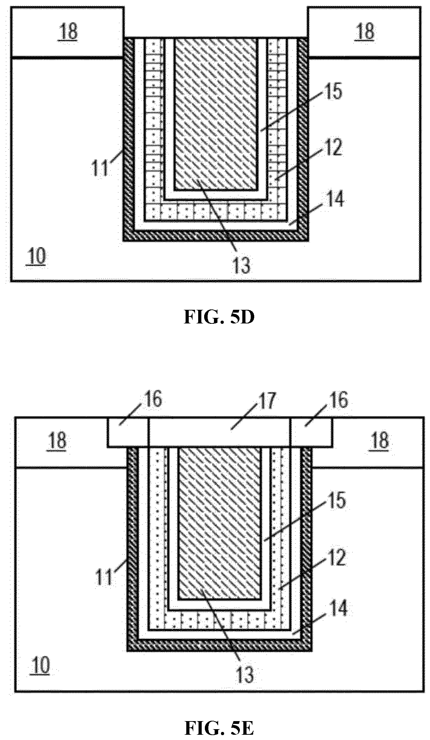

In step S42, a capacitor is filled in the trench 50. The capacitor includes a lower electrode 11 disposed on the inner walls of the trench 50, a dielectric combination layer disposed on the lower electrode 11, and an upper electrode 13 disposed on the combination layer. The dielectric combination layer includes a stacked structure composed of a nitride and an oxide, as shown in FIG. 5E.

Optionally, the substrate includes a first-type doped region 10 and a second-type doped region 18 located above the first-type doped region 10, and the trench 50 penetrates the second-type doped region. The second-type doped region 18 extends to the first-type doped region 10. The specific steps of filling the capacitor in the trench 50 include the following.

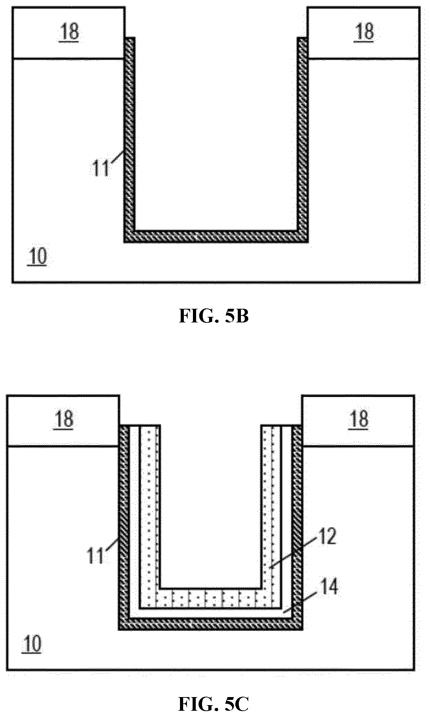

The lower electrode 11 is formed covering the inner walls of the trench 50 in the first-type doped region 10, as shown in FIG. 5B.

Optionally, the specific steps of filling the capacitor in the trench 50 further include the following.

The dielectric combination layer is formed in the trench 50 in the first-type doped region 10, and the dielectric combination layer is disposed on the surface of the lower electrode 11.

Specifically, after the trench 50 is formed, the lower electrode 11, the dielectric combination layer, and the upper electrode 13 are sequentially deposited in the trench 50 in the first-type doped region 10. The upper electrode 13 fills up the region surrounded by the dielectric combination layer to form a plug-like shape.

Optionally, after the capacitor is filled in the trench, the method further includes the following step.

A capacitor contact structure 17 electrically connected to the upper electrode 13 is formed above the upper electrode 13.

Optionally, the method for forming the semiconductor structure further includes the following step.

An isolation structure 16 is formed above the lower electrode 11, and the isolation structure 16 covers the top surface of the lower electrode 11 and is used to isolate the lower electrode 11 and the capacitor contact structure 17.

Optionally, the oxide includes one or a combination of two or more of ZrO₂, Ta₂O₅, Al₂O₃, TiO₂ and HfO₂.

Hereinafter, an illustration is made by taking the case in which the material of the lower electrode 11 and the material of the upper electrode 13 are both N-type polysilicon material as an example. After forming the trench 50 as shown in FIG. 5A, a vapor deposition process is applied to deposit polysilicon material on the surfaces of the side walls and bottom wall of the trench 50 to form an initial lower electrode; then, N-type ions are doped to the initial lower electrode to forms the lower electrode 11, as shown in FIG. 5B. Then, the surface of the lower electrode 11 is subjected to a nitriding treatment, for example, a rapid thermal nitriding process is applied, either nitrogen or ammonia is introduced as a nitrogen source to perform the nitriding treatment on the surface of the lower electrode 11 to form the nitride 14 having the material of silicon nitride. Then, an oxide r 12 is deposited on the surface of the nitride r 14 by a vapor deposition process, thus the nitride layer 14 and the oxide layer 12 form the stacked structure, as shown in FIG. 5C. The oxide 12 may be a single-layer structure, or may be a multi-layer structure sequentially stacked along the radial directions of the trench 50, which can be selected by those of ordinary skill in the art according to actual needs. Then, a vapor deposition process is used to deposit an adhesion layer 15 on the surface of the oxide 12 and the upper electrode 13 fills up the region surrounded by the adhesion layer 15, as shown in FIG. 5D. In the process of forming the upper electrode 13, polysilicon material may be filled in the region surrounded by the adhesion layer 15 to form an initial upper electrode; then N-type ions are implanted into the initial upper electrode to form the upper electrode 13. FIG. 5D shows the capacitor structure formed in this embodiment. After that, the side of the second-type doped region 18 facing the trench 50 can be subjected to etching and depositing processes to form an annular-shaped isolation structured. A conductive material is filled in the region surrounded by the isolation structure 16 to form the capacitor contact structure 17, as shown in FIG. 5E.

According to the semiconductor structure and the method for forming the semiconductor structure provided in these embodiments, by forming a trench in the substrate and filling a capacitor in the trench, surface areas of an upper electrode, a lower electrode and a dielectric combination layer in the capacitor are greatly increased, thereby achieving an increase in the capacitance value of the capacitor, so that even as the DRAM size continues to shrink, the capacitance value of the capacitor can still maintain a high level. In addition, the dielectric combination layer including a nitride/oxide stack structure is provided between the upper electrode and the lower electrode of the capacitor, such that the dielectric constant of the dielectric combination layer is greatly increased, as the result, the leakage current is effectively improved, the capacitance is increased, and the electrical performance of the semiconductor memory device is improved.

The above are embodiments of the present disclosure. It should be pointed out that several improvements and modifications can be made, for those of ordinary skill in the art, without departing from the principle of the present disclosure, and these improvements and modifications should also be regarded as within the scope of protection of the present disclosure.

## Claims

1. A semiconductor structure, **characterized in that**, the semiconductor structure comprises:
a substrate comprising a trench extending along a direction of the substrate;
a capacitor filled in the trench, wherein the capacitor comprises a lower electrode provided on an inner wall of the trench, a dielectric combination layer provided on the lower electrode, and an upper electrode provided on the dielectric combination layer;
wherein the dielectric combination layer comprises a stacked structure composed of a nitride and an oxide.

2. The semiconductor structure of claim 1, wherein the substrate further comprises a first-type doped region and a second-type doped region located above the first-type doped region, wherein the trench penetrates through the second-type doping region and extends to the first-type doped region, and wherein the lower electrode covers the inner wall of the trench in the first-type doped region.

3. The semiconductor structure of claim 2, wherein the dielectric combination layer is disposed in the trench in the first-type doped region.

4. The semiconductor structure of claim 1, further comprising a capacitor contact structure formed above the upper electrode and connected to the upper electrode.

5. The semiconductor structure of claim 4, further comprising an isolation structure formed above the lower electrode, wherein the isolation structure covers a top surface of the lower electrode, for isolating the lower electrode from the capacitor contact structure.

6. The semiconductor structure of claim 1, wherein the oxide comprises one or more of ZrO₂, Ta₂O₅, Al₂O₃, TiO₂ and HfO₂.

7. A method for forming a semiconductor structure, **characterized in that**, the method comprises steps of:
forming a substrate, comprising a trench extending along a direction of the substrate; and
filling a capacitor in the trench, wherein the capacitor comprises a lower electrode disposed on an inner wall of the trench, a dielectric combination layer disposed on the lower electrode, and an upper electrode disposed on the dielectric combination layer; and the dielectric combination layer comprises a stacked structure composed of a nitride and an oxide.

8. The method for forming the semiconductor structure according to claim 7, wherein the substrate further comprises a first-type doped region and a second-type doped region located above the first-type doped region, and the trench penetrates through the second-type doped region and extends to the first-type doped region; and
wherein, filling the capacitor in the trench comprises:
forming the lower electrode covering the inner wall of the trench in the first-type doped region.

9. The method for forming the semiconductor structure according to claim 8, wherein filling the capacitor in the trench further comprises:
forming the dielectric combination layer in the trench in the first-type doped region, in which the dielectric combination layer covers a surface of the lower electrode.

10. The method for forming the semiconductor structure according to claim 7, wherein after filling the capacitor in the trench, the method further comprises forming a capacitor contact structure above the upper electrode, which is electrically connected to the upper electrode.

11. The method for forming the semiconductor structure according to claim 10, wherein the method further comprises forming an isolation structure above the lower electrode, in which the isolation structure covers a top surface of the lower electrode for isolating the lower electrode and the capacitor contact structure.

12. The method for forming the semiconductor structure according to claim 7, wherein the oxide comprises one or more of ZrO₂, Ta₂O₅, Al₂O₃, TiO₂ and HfO₂.
